# FASCICULE DE BREVET EUROPEEN

(11) **EP 3 232 481 B1**
(45) Date de publication et mention de la délivrance du brevet: **28.11.2018**
(21) Numéro de dépôt: 17166706.6
(22) Date de dépôt: 14.04.2017
(51) Int. Cl.: H01L 31/0224, C25D 5/00, C25D 5/02, C25D 7/12, C25D 3/38

(54) **PROCÉDÉ DE MODIFICATION D'UNE SURFACE EN OXYDE CONDUCTEUR DE L'ÉLECTRICITÉ, UTILISATION POUR L'ÉLECTRODÉPOSITION DE CUIVRE SUR CETTE DERNIÈRE**
VERFAHREN ZUR MODIFIZIERUNG EINER OBERFLÄCHE AUS ELEKTRISCH LEITFÄHIGEM OXID, VERWENDUNG ZUR ABSCHEIDUNG VON KUPFER AUF DIESELBE
PROCESS FOR MODIFIYING A SURFACE OF ELECTRICALLY CONDUCTIVE OXIDE, USE FOR THE ELECTRODEPOSITION OF COPPER THEREON

(30) Priorité: 15.04.2016 FR 1653345
(43) Date de publication de la demande: 18.10.2017
(73) Titulaire: Commissariat à l'Energie Atomique et aux Energies Alternatives, 75015 Paris (FR)
(72) Inventeur: BOURLIER, Yoan, 78220 VIROFLAY (FR); BERTHELOT, Thomas, 91940 LES ULIS (FR)
(74) Mandataire: Brevalex

(56) Documents cités:
- US-A- 4 586 988
- US-A1- 2015 349 152
- JAE JEONG KIM ET AL: "Optimized Surface Treatment of Indium Tin Oxide (ITO) for Copper Electroless Plating", JAPANESE JOURNAL OF APPLIED PHYSICS, vol. 41, no. Part 2, No. 11A, novembre 2002 (2002-11), pages 1269-1271, XP055315494, JP ISSN: 0021-4922, DOI: 10.1143/JJAP.41.L1269
- KHANNA ANKIT ET AL: "Screen-printed masking of transparent conductive oxide layers for copper plating of silicon heterojunction cells", APPLIED SURFACE SCIENCE, vol. 349, 21 mai 2015 (2015-05-21), pages 880-886, XP029205727, ISSN: 0169-4332, DOI: 10.1016/J.APSUSC.2015.05.085

## Description

### DOMAINE TECHNIQUE

L'invention se situe dans le domaine de la physico-chimie des matériaux et plus précisément de la métallisation de surfaces en oxyde conducteur de l'électricité telles que des surfaces d'oxyde d'indium-étain ou ITO (pour « Indium Tin Oxide »).

Tout d'abord, la présente invention concerne un procédé pour former à la surface d'un substrat en oxyde conducteur de l'électricité un film de cuivre métallique sans couche d'accroche et sans couche de germination en soumettant au préalable la surface du substrat en oxyde conducteur de l'électricité à un traitement à deux étapes modifiant les propriétés physico-chimiques de cette surface. La présente invention concerne également le procédé de modification en tant que tel.

Enfin, la présente invention concerne les surfaces d'un substrat en oxyde conducteur de l'électricité modifiée et métallisée par mise en oeuvre de ces procédés ainsi que leurs différentes utilisations notamment dans le domaine des cellules photovoltaïques.

### ÉTAT DE LA TECHNIQUE ANTÉRIEURE

Les cellules photovoltaïques (cellules PV) sont des dispositifs capables de convertir l'énergie solaire en énergie électrique grâce à l'utilisation de matériaux semiconducteurs, pour produire un effet photovoltaïque. Réduire le coût de revient des cellules PV pourrait promettre un bel avenir à l'ensemble de la filière. Plus de 30% du coût de production est aujourd'hui attribué à la réalisation des contacts métalliques. Paradoxalement, les pertes électriques dues à ces mêmes contacts sont également de l'ordre de 30%. Il est donc envisageable d'augmenter la performance des cellules PV à hétérojonction tout en réduisant leur coût, sans s'attaquer à leurs structures, mais simplement en améliorant la grille de contact métallique en surface.

La majorité des contacts métalliques des cellules PV à hétérojonction est réalisée par sérigraphie de pâte d'argent à basse température (< 200°C). Ce procédé est rapide et possède une bonne reproductibilité. Il est, de ce fait, facilement industrialisable. Cependant, le prix de l'argent reste très élevé, ce qui accroît énormément le prix de revient. De plus, la sérigraphie utilise énormément de matière par rapport à d'autres procédés et elle donne lieu à des lignes de métallisation trop larges (entre 80 µm et 100 µm), ce qui entraîne des effets d'ombre importants.

Les alternatives à la sérigraphie de pâte d'argent proposées se font donc sur deux plans, à savoir (i) la technique de dépôt et (ii) le matériau à déposer.

Dans ce 2^{nd} cas, le meilleur candidat pour remplacer l'argent est sûrement le cuivre puisqu'il possède une très faible résistivité (1,68 µΩ.cm) équivalente à celle de l'argent (1,59 µΩ.cm) tout en étant 100 fois moins cher que l'argent.

Pour le dépôt de contacts en cuivre, des pâtes pour sérigraphie à base de cuivre, des encres basses températures et en frittage flash à base de nanoparticules de cuivre sont développées ; cependant la résistivité des lignes demeure élevée i.e. supérieure à 20 µΩ.cm.

Deux autres procédés issus de l'électrochimie sont également utilisés pour déposer les contacts en cuivre. Ils sont particulièrement intéressants du fait qu'ils confèrent, à la grille de métallisation, une résistivité très faible i.e. de l'ordre de 2 µΩ.cm. Ces procédés sont, d'une part, le procédé ECD (pour « Electro-Chemical Deposition ») et, d'autre part, le procédé LIP (pour « Light InducedPlating »). Le procédé ECD consiste à venir réduire les sels métalliques présents dans l'électrolyte en surface de la cellule PV et ce, en appliquant un courant électrique. Quant au procédé LIP, il se base sur les mêmes principes chimiques mais fait intervenir les propriétés photovoltaïques de la cellule PV. Ainsi, cette dernière est soumise à un éclairement et induit elle-même le courant nécessaire à la réduction des sels métalliques en surface.

Les procédés ECD et LIP présentent de nombreux avantages par rapport aux techniques d'impression : ils permettent des dépôts denses et d'une grande pureté, avec une résistivité équivalente à celle des métaux massifs. De plus, la quantité de métal utilisée par ces procédés est minimisée. Un 1^{er} désavantage rencontré pour tout procédé par immersion est que les motifs de la grille de contact (ou « pattern ») ne sont pas directement réalisés en comparaison avec les autres procédés d'impression. Il est donc nécessaire de réaliser une étape de masquage en surface de la cellule PV.

Le procédé LIP apparaît comme un moyen efficace de métalliser les cellules solaires et est bien adapté aux dépôts de cuivre, le record de rendement des cellules métallisées avec du cuivre selon le procédé LIP atteignant 21,8% [1]. Pourtant, ce procédé reste très peu utilisé dans le cas des cellules à hétérojonction. En effet, pour des raisons électriques, le procédé LIP est seulement réalisable sur le côté dopé n de la cellule. Dans le cas d'une cellule à hétérojonction, la grille métallique en face avant est connectée à la face dopée p (contrairement à une cellule en silicium à homojonction), rendant ainsi le procédé LIP impossible et seulement applicable en face arrière. De plus, l'électrodépôt de cuivre selon le procédé LIP n'est pas directement applicable en surface de l'ITO pour des problèmes d'adhésion et la présence d'une couche d'accroche est nécessaire.

Le procédé ECD découle de la technologie des cellules silicium à homojonction pour lesquelles l'empreinte des lignes de contact est creusée dans la couche d'antireflet en surface (ou ARC pour « Anti Reflection Coating ») par ablation laser **[2].** Le procédé ECD a ensuite été transféré sur les cellules PV à hétérojonction **[3-4].** Le masquage par ablation laser y est remplacé par la photolithographie, soit par impression d'un masque de résine, soit par impression jet d'encre sur résine. La présence d'ITO en surface de la cellule PV à hétérojonction constitue en elle-même une barrière contre la diffusion du cuivre. Cependant, l'électrodépôt de cuivre n'est apparemment pas directement applicable en surface de l'ITO pour des problèmes d'adhésion **[5].** L'électrodépôt de nickel ne faisant plus office de barrière de diffusion devient alors la couche d'accroche la plus souvent employée. Le nickel sert alors de transition entre l'oxyde qui est constitué principalement d'indium (>90%) et le cuivre réduit en surface.

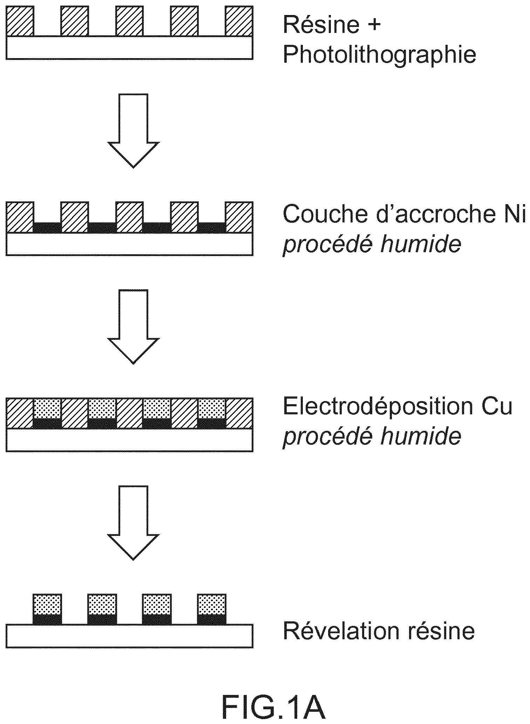

Les performances des cellules PV à hétérojonction métallisées par ECD atteignent, à présent, 24,2% **[3]** en laboratoire et 22,3% sur des modules de grande surface (cellule de 153 cm²) **[6].** Ce procédé ECD couramment utilisé dans la littérature est désigné procédé « ECD Ni-Cu » (Figure 1A). Bien que présentant de nombreux avantages tels que décrits ci-dessus, le procédé ECD Ni-Cu peut difficilement concurrencer la technologie de la sérigraphie de pâtes d'argent. Deux principales limitations sont en cause : le nombre d'étapes nécessaires à la réalisation des contacts métalliques qui constitue un frein économique incontestable et la résistance de contact ITO/Ni/Cu beaucoup trop élevée pour que les cellules PV issues de ce procédé puissent atteindre les performances électriques record des cellules à hétérojonction aux contacts métalliques en argent (atteignant 25,6%) **[7].**

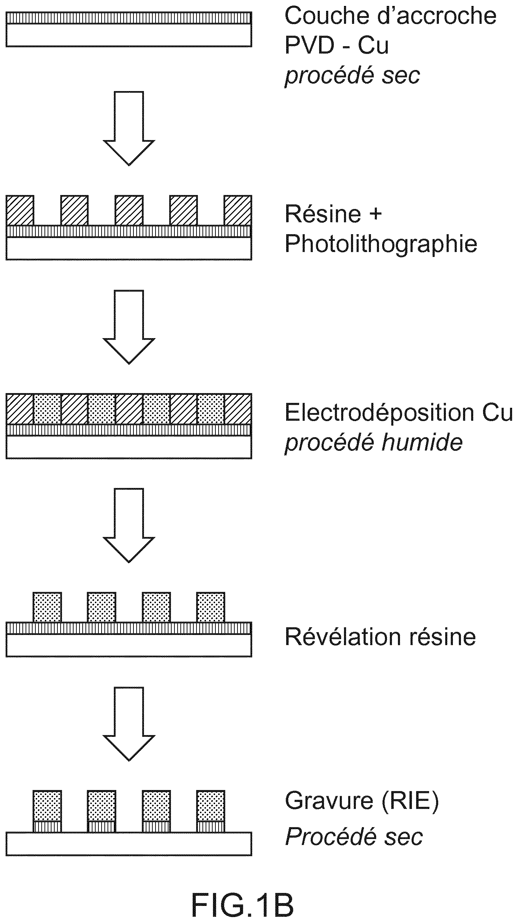

Afin d'améliorer les performances électriques de la cellule PV, un procédé ECD utilisant exclusivement du cuivre a été développé, ce procédé étant désigné « ECD Cu » (Figure 1B). Du fait de la résistivité plus faible du cuivre par rapport au nickel, le contact électrique ITO/Cu sera plus performant que le contact ITO/Ni/Cu. La couche d'accroche utilisée par le procédé ECD Cu est une couche mince de 50 nm environ de cuivre métallique déposé par PVD (pour « Physical Vapor Déposition »). Cette étape de dépôt physique sous vide (« dry process ») non seulement est très chère et difficilement intégrale en ligne de production, mais aussi elle nécessite une étape de gravure RIE (pour « Reactive Ion Etching ») supplémentaire en fin de procédé et ce, pour éliminer le cuivre sur la couche d'ITO non métallisée.

La demande de brevet US 2015/0349152 proposé un procédé de métallisation d'une cellule PV, typiquement en silicium, présentant un revêtement en oxyde métallique comprenant le dépôt, sur ce revêtement, d'une couche de résine et son élimination en des sites donnés, le dépôt d'une couche de germination et le dépôt électrolytique d'une couche de métal ou d'alliage métallique, avant une succession d'étapes de décapage.

A ce jour, aucun procédé permettant de diminuer drastiquement les coûts de production liés à la métallisation des cellules photovoltaïques n'a vu le jour. En effet, l'utilisation de nickel offre une bonne adhésion des contacts métalliques mais ce dernier constitue un frein au rendement électrique de la cellule du fait de sa résistivité plus élevée que celle du cuivre (8,7 Ω.cm pour Ni contre 1,7 Ω.cm pour Cu). Le procédé ECD Cu actuellement mis en place permet de s'affranchir du nickel mais il fait intervenir des étapes de dépôt physique impossibles à mettre en oeuvre dans une ligne de production car beaucoup trop coûteuses.

Les inventeurs se sont donc fixé pour but de proposer un procédé pour la production de cellules photovoltaïques à hétérojonction facile à mettre en oeuvre, peu coûteux et grâce auquel sont obtenues des cellules dont les rendements électriques rendent envisageables une exploitation industrielle.

### EXPOSÉ DE L'INVENTION

Les inventeurs ont atteint le but fixé en proposant un procédé d'électrodéposition, en solution directe, de cuivre métallique sur l'ITO. Ce procédé permet de former, en solution, du cuivre métallique en surface d'un matériau recouvert d'ITO sans création d'une sous-couche barrière et sans dépôt préalable d'un primaire d'adhésion. Cette couche de cuivre possède une intimité avec l'ITO structuré ou non permettant notamment d'assurer un transfert d'électrons optimal entre ces deux couches.

Afin de développer un procédé compétitif et industrialisable de métallisation de surfaces en ITO qui préserve le contact électrique ITO/Cu, les inventeurs ont développé un procédé utilisant exclusivement la chimie des solutions (« wet process » pour « procédé humide ») afin de modifier la surface d'ITO après le masquage, éliminant ainsi toutes les étapes de « dry process » (pour « procédé sec ») des procédés de l'art antérieur.

Plus particulièrement, les inventeurs ont mis au point un procédé chimique à deux étapes grâce auquel les propriétés physico-chimiques de la couche d'ITO sont modifiées en surface. Ce procédé de modification met en oeuvre successivement un premier bain contenant du sulfate de cuivre et de l'ammoniac et un second bain contenant du tétraborohydrure de sodium.

Plusieurs essais d'électrodépôt de cuivre directement sur une cellule PV à surface d'ITO et sans aucun traitement chimique au préalable, ont permis aux inventeurs de vérifier l'absence totale d'adhésion des films de Cu sur l'ITO, conformément aux observations décrites dans la littérature **[6,8].** Seule la modification de surface de l'ITO par mise en contact successives avec les deux bains décrits ci-dessus est à l'origine de la bonne adhésion du film de cuivre formé sur la surface d'ITO.

Sans vouloir être tenu par une quelconque théorie, on peut supposer que la mise en contact de la surface d'ITO avec le premier bain permet la création de « ligands » entre les complexes [Cu(NH₃)₄]²⁺ et cette surface. Seuls les complexes cuivre-ammoniaque sont supposés permettre une interaction avec le film d'ITO, par exemple, avec les liaisons pendantes métal-hydroxydes et notamment In-OH en surface du film d'ITO. La seconde étape fait intervenir un bain contenant du NaBH₄ qui est un puissant agent réducteur. Les inventeurs ont constaté que la combinaison de ces deux étapes permet la structuration et la modification chimique de l'ITO plutôt que l'apparition de nanoparticules ou clusters de cuivre sur la surface (cf partie expérimentale ci-après).

Enfin, il convient de souligner que le choix des constituants des différents bains mis en oeuvre dans le procédé de modification selon l'invention n'est nullement arbitraire. En effet, seule la combinaison des deux étapes impliquant un premier bain contenant du sulfate de cuivre et de l'ammoniac et un second bain contenant du tétraborohydrure de sodium permet la modification de surface de l'ITO. D'autres formulations de bains ont été testées avec, pour le premier bain, notamment des bains contenant du nickel et de l'ammoniac et/ou, pour le second bain, d'autres agents réducteurs comme l'acide hypophosphoreux (H₃PO₂), le diméthyl-amino-borane (DMAB) ou l'acide ascorbique (C₆H₈O₆) sans résultat. Seuls les éléments constituant les deux bains définis ci-dessus permettent d'obtenir une modification physico-chimique de la surface d'ITO grâce à laquelle une bonne adhésion avec le film de cuivre métallique électrodéposé est obtenue.

De façon particulièrement intéressante, le procédé selon la présente invention s'applique non seulement aux substrats en ITO mais également à tout substrat en oxyde métallique conducteur de l'électricité que ce substrat soit opaque ou transparente tel que des substrats d'OTC pour « Oxyde Transparent et Conducteur » (ou TCO en anglais).

La présente invention concerne, donc, tout d'abord, un procédé pour modifier la surface d'un substrat en oxyde métallique conducteur de l'électricité, ledit procédé comprenant les étapes suivantes consistant à :
i) mettre en contact la surface dudit substrat en oxyde métallique conducteur de l'électricité avec une solution contenant au moins un ion cuivrique (Cu²⁺) et au moins de l'ammoniac puis laver et éventuellement sécher la surface dudit substrat en oxyde métallique conducteur de l'électricité ainsi obtenue ;
ii) mettre en contact la surface dudit substrat en oxyde métallique conducteur de l'électricité obtenue suite à l'étape (i) avec une solution contenant du tétraborohydrure de sodium puis laver et éventuellement sécher la surface dudit substrat en oxyde métallique conducteur de l'électricité.

Moyennant quoi la surface qui est obtenue suite à l'étape (ii) est une surface d'un substrat en oxyde métallique conducteur de l'électricité modifiée.

L'oxyde métallique conducteur de l'électricité mis en oeuvre dans le cadre de la présente invention peut être opaque ou transparent dans le visible et le proche infrarouge. Avantageusement, cet oxyde métallique conducteur est transparent dans le visible et le proche infrarouge. Ainsi, l'oxyde métallique conducteur mis en oeuvre dans le cadre de la présente invention est un oxyde transparent et conducteur (OTC).

L'oxyde métallique conducteur de l'électricité mis en oeuvre dans le cadre de la présente invention est choisi dans le groupe constitué par un oxyde d'indium éventuellement dopé, un oxyde d'étain éventuellement dopé, un oxyde de zinc éventuellement dopé, un oxyde de cadmium éventuellement dopé, un oxyde de gallium éventuellement dopé, un oxyde de thallium éventuellement dopé, un oxyde de plomb éventuellement dopé, un oxyde d'antimoine éventuellement dopé, un oxyde de niobium éventuellement dopé, un oxyde de tungstène éventuellement dopé, un oxyde de zirconium éventuellement dopé, un oxyde de ruthénium éventuellement dopé, un oxyde de baryum éventuellement dopé, un oxyde de sélénium éventuellement dopé, un oxyde de bismuth éventuellement dopé et leurs mélanges.

Par « éventuellement dopé », on entend un oxyde métallique conducteur de l'électricité comprenant en outre un constituant susceptible de le doper.

Avantageusement, l'oxyde métallique conducteur de l'électricité mis en oeuvre dans le cadre de la présente invention est choisi dans le groupe constitué par l'oxyde d'étain dopé au fluor (SnO₂:F), l'oxyde d'étain dopé à l'arsenic (SnO₂:As), l'oxyde d'étain dopé à l'antimoine (SnO₂:Sb), l'oxyde d'indium dopé à l'étain (ITO), l'oxyde d'indium dopé au zinc (IZO) et l'oxyde de zinc dopé à l'aluminium (ZnO:Al). De façon plus avantageuse encore, le substrat en oxyde métallique conducteur mise en oeuvre dans le cadre de la présente invention est un substrat en ITO, ce substrat étant de structure majoritairement amorphe comprenant un mélange d'oxyde d'indium(III) (In₂O₃) et d'oxyde d'étain(IV) (SnO₂). Typiquement, la proportion massique d'oxyde d'indium(III) dans le substrat en ITO est comprise entre 80 et 98% et notamment est de l'ordre de 90% (i.e. 90% ± 5%), alors que la proportion massique d'oxyde d'étain(IV) est comprise entre 2 et 20% et notamment est de l'ordre de 10% (i.e. 10% ± 5%).

Le substrat en oxyde métallique conducteur de l'électricité peut se présenter sous forme d'un support solide en oxyde métallique conducteur de l'électricité ou d'un revêtement ou couche en oxyde métallique conducteur de l'électricité d'une épaisseur comprise entre 50 nm et 1 mm déposé(e) sur un support solide en un autre matériau tel que du silicium cristallin, un plastique, une résine ou un verre. Le substrat en oxyde métallique conducteur de l'électricité mis en oeuvre dans le cadre de la présente invention peut présenter n'importe quelle taille ou forme.

Préalablement à la mise en oeuvre du procédé de modification selon la présente invention, la surface du substrat en oxyde métallique conducteur de l'électricité peut éventuellement être soumise à un nettoyage au solvant comme, par exemple, à l'acétone ou à l'éthanol et/ou au détergent comme un détergent industriel du type TFD4. Ce nettoyage peut être réalisé sous ultrasons. Ce nettoyage peut être complété par un pré-traitement par irradiation UV, par plasma d'argon et/ou par plasma d'oxygène. Ces étapes de nettoyage et de pré-traitement sont utilisées pour éviter toute pollution ou contamination par des agents externes comme des polluants organiques.

Par « modifier une surface en oxyde métallique conducteur de l'électricité », on entend, dans le cadre de la présente invention, soumettre la surface en oxyde métallique conducteur de l'électricité à un traitement suite auquel les propriétés physico-chimiques de la surface en oxyde métallique conducteur de l'électricité sont différentes des propriétés physico-chimiques de cette même surface avant mise en oeuvre dudit traitement. Ainsi au moins une des propriétés choisies parmi les propriétés électriques, les propriétés optiques, les propriétés morphologiques et les propriétés chimiques est modifiée suite au procédé de modification selon la présente invention. Avantageusement au moins deux ou au moins trois des propriétés listées ci-dessus sont modifiées. Typiquement l'ensemble des propriétés listées ci-dessus sont modifiées suite au procédé de modification selon la présente invention.

En ce qui concerne les propriétés électriques, la surface du substrat en oxyde métallique conducteur de l'électricité telle qu'une surface en ITO soumise au procédé de modification selon la présente invention présente une résistance par carré au moins deux fois plus élevée, notamment au moins trois fois plus élevée et avantageusement au moins quatre fois plus élevée que la résistance par carré de la même surface non soumise audit procédé de modification. De même, la surface du substrat en oxyde métallique conducteur de l'électricité telle qu'une surface en ITO soumise au procédé de modification selon la présente invention présente une différence de potentiel comprise entre 0,2 et 2 V, notamment entre 0,3 et 1 V et avantageusement de l'ordre de 0,5 V (i.e. 0,5 V ± 0,1 V) vis-à-vis de la même surface non soumise audit procédé de modification, les mesures de tension étant réalisées en circuit ouvert.

En ce qui concerne les propriétés optiques, la surface du substrat en oxyde métallique conducteur de l'électricité telle qu'une surface en ITO soumise au procédé de modification selon la présente invention présente une absorbance dans le domaine du visible modifiée i.e. différente de l'absorbance dans le domaine du visible de la même surface non soumise audit procédé de modification. Il résulte de cette différence d'absorbance que la surface du substrat en oxyde métallique conducteur de l'électricité telle qu'une surface en ITO soumise au procédé de modification selon la présente invention présente une couleur différente de celle de la même surface non soumise audit procédé de modification. Ainsi lorsque le substrat en oxyde métallique conducteur de l'électricité est un film d'ITO déposé sur du silicium cristallin, la surface d'un tel substrat soumise au procédé de modification selon la présente invention présente une couleur gris clair, alors que la même surface non soumise audit procédé de modification est bleue.

En ce qui concerne les propriétés morphologiques, la surface du substrat en oxyde métallique conducteur de l'électricité telle qu'une surface en ITO soumise au procédé de modification selon la présente invention est granuleuse comparée à la même surface non soumise audit procédé de modification. En effet, lorsque la surface du substrat en oxyde métallique conducteur de l'électricité est une surface en ITO, cette dernière soumise au procédé de modification selon la présente invention présente une couche uniforme constituée de grains d'ITO dont le diamètre moyen est compris entre 50 nm et 300 nm et notamment entre 80 nm à 200 nm.

En ce qui concerne les propriétés chimiques, la surface du substrat en oxyde métallique conducteur de l'électricité telle qu'une surface en ITO soumise au procédé de modification selon la présente invention présente une structure cristallographique modifiée par rapport à celle de la même surface non soumise audit procédé de modification. Ainsi, lorsque la surface du substrat en oxyde métallique conducteur de l'électricité est une surface en ITO, ce substrat soumis au procédé de modification selon la présente invention comprend, outre de l'ITO, de l'indium sous forme métallique. Typiquement la quantité d'indium métallique en masse est comprise entre 5 et 25%, notamment entre 10 et 20% et avantageusement de l'ordre de 16% (i.e. 16% ± 2%) par rapport à la masse totale du substrat en ITO (i.e. masse ITO + indium métallique). A noter également que la surface du substrat en ITO soumise au procédé de modification selon la présente invention ne présente pas de nanoparticules de cuivre métallique ou d'oxyde de cuivre.

L'étape (i) du procédé selon la présente invention consiste en la mise en contact de la surface d'un substrat en oxyde métallique conducteur de l'électricité avec une solution, désignée ci-après solution S₁, contenant deux éléments distincts que sont (1) au moins un ion Cu²⁺ et (2) au moins de l'ammoniac puis laver et éventuellement sécher la surface du substrat en oxyde métallique conducteur de l'électricité ainsi obtenue. En d'autres termes et sur la base des explications théoriques ci-dessus, cette étape vise à créer des « ligands » entre les complexes [Cu(NH₃)₄]²⁺ et la surface du substrat en oxyde métallique conducteur de l'électricité.

Dans la solution S₁, l'ion Cu²⁺ se trouve sous forme d'un sel de cuivre. Ce sel est avantageusement choisi dans le groupe constitué par un nitrate, un sulfate, un acétate, un halogénure, un tétrafluoroborate et l'une quelconque de leurs formes hydratées. Par « halogénure », on entend un chlorure, un bromure, un iodure ou un fluorure. Avantageusement, le sel de cuivre mis en oeuvre est du sulfate de cuivre (CuSO₄) et notamment du sulfate de cuivre pentahydraté (CuSO₄.5H₂O). Le sel de cuivre est présent, dans la solution S₁, en une quantité comprise entre 0,05 et 0,25 mol/L et avantageusement entre 0,06 et 0,2 mol/L.

La solution S₁ comprend, en plus des ions Cu²⁺ tels que décrits ci-dessus, de l'ammoniac. Typiquement, l'ammoniac est présent, dans la solution S₁, en une quantité comprise entre 1 et 6 mol/L et avantageusement entre 1,5 et 5 mol/L. Ainsi, le pH de la solution S₁ est avantageusement compris entre 10 et 14 et notamment entre 11 et 13.

La solution S₁ comprend, en plus des ions Cu²⁺ et de l'ammoniac tels que décrits ci-dessus, un solvant. Ce solvant est avantageusement de l'eau qui peut aussi bien être de l'eau désionisée, de l'eau distillée que de l'eau ultra-pure (18,2 MΩ). Typiquement, le solvant dans la solution S₁ est de l'eau désionisée. Ainsi, la solution S₁ est une solution aqueuse ammoniacale comprenant un sel de cuivre et typiquement du sulfate de cuivre. Dans la solution S₁, l'ammoniac (NH₃) est dissous, ce qui donne, lorsque le solvant de la solution S₁ est de l'eau, une solution aqueuse basique de l'ammoniac notée NH₃.H₂O, NH₄OH ou encore NH_{3 aqueux}.

Avantageusement, la solution S₁ ne comprend qu'un sel de cuivre et de l'ammoniac dans un solvant. Un exemple particulier de cette forme de mise en oeuvre est une solution aqueuse ammoniacale ne comprenant qu'un sel de cuivre et typiquement que du sulfate de cuivre.

En variante, la solution S₁ peut comprendre un ou plusieurs autre(s) élément(s) en plus des ions Cu²⁺, de l'ammoniac et du solvant. Typiquement, cet autre élément peut être un sel d'un métal de liaison comme un sel ferreux, un sel ferrique, un sel de nickel, un sel de cobalt ou un sel de zinc. Ce sel d'un métal de liaison est avantageusement choisi dans le groupe constitué par un nitrate, un sulfate, un acétate, un halogénure, un tétrafluoroborate et l'une quelconque de leurs formes hydratées. A titre d'exemple particulier d'un tel sel d'un métal de liaison susceptible d'être présent dans la solution S₁ en plus des ions Cu²⁺ et de l'ammoniac, on peut citer du sulfate de nickel.

La solution S₁ peut être préparée, de façon extemporanée ou non, à partir de composés accessibles dans le commerce. En variante, cette solution peut être une solution commerciale comme, par exemple, la solution Pegactiv A2 de Pegastech.

L'étape (i) du procédé selon l'invention est effectuée à une température comprise entre 10°C et 30°C, avantageusement entre 15°C et 25°C et, plus particulièrement, à température ambiante (i.e. 21°C±3°C) et ce, généralement durant de 1 min à 1 h, notamment durant de 5 min à 30 min et, en particulier, durant de l'ordre de 15 min (i.e. 15 min ± 5 min).

La mise en contact lors de l'étape (i) peut être effectuée en mode statique ou en mode dynamique. Dans le « mode statique » également appelé « mode batch », la surface du substrat en oxyde métallique conducteur de l'électricité est plongée dans la solution S₁, cette dernière étant éventuellement soumise à une agitation. Dans le « mode dynamique » également appelé « mode colonne », la solution S₁ s'écoule sur la surface du substrat en oxyde métallique conducteur de l'électricité.

A l'issue de cette mise en contact, la surface du substrat en oxyde métallique conducteur de l'électricité est soumise à un lavage. Un tel lavage vise à éliminer le sel de cuivre et l'ammoniac en excès ainsi que les ions Cu²⁺ non impliqués dans des ligands tels que précédemment définis.

Si la mise en contact a été effectuée en mode statique, la surface du substrat en oxyde métallique conducteur de l'électricité est retirée de la solution S₁ puis est lavée en la plongeant dans une solution de lavage ou en faisant s'écouler la solution de lavage sur ladite surface. Si la mise en contact a été effectuée en mode dynamique, on remplace la solution S₁ s'écoulant sur la surface du substrat en oxyde métallique conducteur de l'électricité par la solution de lavage.

L'étape de lavage et notamment lorsqu'elle implique de plonger la surface du substrat en oxyde métallique conducteur de l'électricité dans une solution de lavage peut être répétée plusieurs fois et notamment au moins deux fois, au moins trois fois ou encore au moins quatre fois. A chaque lavage, une solution de lavage, identique ou différente, peut être mise en oeuvre.

Avantageusement, la solution de lavage utilisée lors de l'étape (i) comprend le même solvant que le solvant de la solution S₁. Typiquement, cette solution de lavage est de l'eau désionisée.

Suite à ce lavage, la surface du substrat en oxyde métallique conducteur de l'électricité peut éventuellement être soumise à un séchage qui n'est cependant pas obligatoire.

L'étape (ii) du procédé selon la présente invention consiste en la mise en contact de la surface du substrat en oxyde métallique conducteur de l'électricité obtenue suite à l'étape (i) i.e. la surface du substrat en oxyde métallique conducteur de l'électricité où sont liés ou adsorbés des complexes [Cu(NH₃)₄]²⁺ avec une solution, désignée ci-après solution S₂, comprenant du tétraborohydrure de sodium puis laver et éventuellement sécher la surface du substrat en oxyde métallique conducteur de l'électricité ainsi obtenue.

Dans la solution S₂ telle que mise en oeuvre lors de l'étape (ii), le tétraborohydrure de sodium est présent en une quantité comprise entre 0,03 et 0,15 mol/L, avantageusement entre 0,06 et 0,1 mol/L et, en particulier, de l'ordre de 0,08 mol/L (i.e. 0,08 mol/L± 0,01 mol/L).

La solution S₂ comprend, en plus du tétraborohydrure de sodium, un solvant. Ce solvant est avantageusement de l'eau qui peut aussi bien être de l'eau désionisée, de l'eau distillée que de l'eau ultra-pure. Typiquement, le solvant dans la solution S₂ est de l'eau désionisée.

L'étape (ii) du procédé selon l'invention est effectuée à une température comprise entre 30°C et 60°C, avantageusement entre 35°C et 50°C et, plus particulièrement, à une température de l'ordre de 40°C (i.e. 40°C ± 5°C) et ce, généralement durant de 1 à 15 min, notamment durant de 2 à 10 min et, en particulier, durant de l'ordre de 5 min (i.e. 5 min ± 2 min).

La mise en contact lors de l'étape (ii) est effectuée en mode statique ou en mode dynamique. Dans le « mode statique » également appelé « mode batch », la surface du substrat en oxyde métallique conducteur de l'électricité est plongée dans la solution S₂, cette dernière étant éventuellement soumise à une agitation. Lorsque la solution S₂ est soumise à une agitation, cette dernière peut faire intervenir un malaxeur, un agitateur, un barreau magnétique, un bain à ultrasons ou un homogénéisateur. Dans le « mode dynamique » également appelé « mode colonne », la solution S₂ s'écoule sur la surface du substrat en oxyde métallique conducteur de l'électricité.

A l'issue de cette mise en contact, la surface du substrat en oxyde métallique conducteur de l'électricité est soumise à un lavage. Un tel lavage vise à éliminer les éléments résiduels issus de la solution S₂ ou les éléments issus de la réaction du tétraborohydrure de sodium avec les complexes présents à la surface du substrat en oxyde métallique conducteur de l'électricité.

Si la mise en contact a été effectuée en mode statique, la surface du substrat en oxyde métallique conducteur de l'électricité est retirée de la solution S₂ puis est lavée en la plongeant dans une solution de lavage ou en faisant s'écouler la solution de lavage sur cette surface. Si la mise en contact a été effectuée en mode dynamique, on remplace la solution S₂ s'écoulant sur la surface du substrat en oxyde métallique conducteur de l'électricité par la solution de lavage.

L'étape de lavage et notamment lorsqu'elle implique de plonger la surface du substrat en oxyde métallique conducteur de l'électricité dans une solution de lavage peut être répétée plusieurs fois et notamment au moins deux fois, au moins trois fois ou encore au moins quatre fois. A chaque lavage, une solution de lavage, identique ou différente, peut être mise en oeuvre.

Avantageusement, la solution de lavage utilisée lors de l'étape (ii) comprend le même solvant que le solvant de la solution S₂. Typiquement, cette solution de lavage est de l'eau désionisée.

Suite à ce lavage, la surface du substrat en oxyde métallique conducteur de l'électricité peut éventuellement être soumise à un séchage qui n'est cependant pas obligatoire.

Comme précédemment expliqué, la combinaison des deux étapes du procédé de modification selon l'invention impliquant un premier bain contenant du sulfate de cuivre et de l'ammoniac et un second bain contenant du tétraborohydrure de sodium entraînent des modifications physico-chimiques de la surface du substrat en oxyde métallique conducteur de l'électricité qui permettent une bonne adhésion du film de cuivre métallique électrodéposé sur cette surface. Dans ce cas, le film de cuivre métallique est en contact direct avec la surface du substrat en oxyde métallique conducteur de l'électricité modifiée. En d'autres termes, aucune autre couche telle qu'une couche de germination ou une couche d'accroche ne s'interpose entre le film de cuivre métallique et la surface du substrat en oxyde métallique conducteur de l'électricité modifiée.

De ce fait, la présente invention concerne également un procédé pour former un film de cuivre métallique sur la surface d'un substrat en oxyde métallique conducteur de l'électricité, ledit procédé comprenant les étapes suivantes consistant à :
a) préparer une surface d'un substrat en oxyde métallique conducteur de l'électricité modifiée conformément au procédé de modification tel que précédemment défini ;
b) électrodéposer du cuivre métallique sur la surface du substrat modifiée préparée lors de l'étape (a).

Tout ce qui a été précédemment décrit pour le procédé de modification selon la présente invention s'applique à l'étape (a) du procédé pour former un film de cuivre métallique sur la surface d'un substrat en oxyde métallique conducteur de l'électricité.

L'étape (b) du procédé pour former un film de cuivre métallique sur la surface d'un substrat en oxyde métallique conducteur de l'électricité est une étape classique dans le domaine du dépôt de métaux sur des surfaces conductrices ou semi-conductrices.

Par « électrodépôt », on entend un procédé consistant à recouvrir la surface d'un substrat par un revêtement métallique dans lequel le substrat est polarisé électriquement et mis en contact d'un liquide contenant des précurseurs dudit revêtement métallique de manière à former ledit revêtement. Les termes et expressions « électrodépôt », « électrodéposition » et « dépôt électrochimique » sont équivalents et utilisables de façon interchangeable.

Dans le cas présent, lors de l'étape (b), le dépôt de cuivre métallique est obtenu par réduction d'ions cuivriques à partir d'une solution les contenant, cette réduction étant induite par des électrons fournis par une source externe de courant. Plus particulièrement, l'électrodépôt est réalisé par passage d'un courant entre le substrat en oxyde métallique conducteur de l'électricité à revêtir constituant la cathode et l'anode inerte et de surface importante comme une grille en titane platiné, dans un bain contenant des ions Cu²⁺ et ce, éventuellement en présence d'une électrode de référence.

Dans le bain d'électrodéposition mis en oeuvre dans le cadre de la présente invention, les ions Cu²⁺ se trouvent sous forme d'un sel de cuivre. Ce sel est avantageusement choisi dans le groupe constitué par un nitrate, un sulfate, un acétate, un halogénure, un tétrafluoroborate et l'une quelconque de leurs formes hydratées. Avantageusement, le sel de cuivre mis en oeuvre est du sulfate de cuivre (CuSO₄) et notamment du sulfate de cuivre pentahydraté (CuSO₄.5H₂O). Le sel de cuivre est présent, dans le bain d'électrodéposition, en une quantité comprise entre 0,05 et 0,7 mol/L, en particulier, entre 0,1 et 0,5 mol/L, et avantageusement entre 0,2 et 0,4 mol/L.

Typiquement, le bain d'électrodéposition mis en oeuvre dans le cadre de la présente invention est une solution aqueuse acide contenant des ions Cu²⁺. Par conséquent, ce bain d'électrodéposition comprend au moins un acide organique, comme l'acide acétique ou inorganique et notamment un acide choisi dans le groupe constitué par l'acide chlorhydrique (HCl), l'acide sulfurique (H₂SO₄), l'acide nitrique (HNO₃), l'acide phosphorique (H₃PO₄) et un de leurs mélanges. A titre d'exemple particulier de mélanges d'acides utilisables dans le cadre de la présente invention, on peut citer un mélange d'acide chlorhydrique (HCl) et d'acide sulfurique (H₂SO₄).

Enfin, le bain d'électrodéposition mis en oeuvre dans le cadre de la présente invention peut éventuellement comprendre un ou plusieurs additif(s) destiné(s) à améliorer les propriétés du revêtement formé telles que la régularité et la finesse du dépôt et sa résistivité. Un exemple d'un tel additif est un agent brillanteur organique comme le Copper Gleam PC Additive, (Pegastech).

Dans une forme de mise en oeuvre particulière de l'étape (b) du procédé selon l'invention, cette dernière peut notamment être réalisée en effectuant les étapes suivantes:
- une étape dite d' « entrée à froid » au cours de laquelle la surface du substrat en oxyde métallique conducteur de l'électricité modifiée obtenue suite à l'étape (a) est mise en contact sans polarisation électrique avec un bain d'électrodéposition et typiquement maintenue dans cet état pendant une durée d'au moins 5 secondes, notamment comprise entre 10 et 60 secondes, et en particulier comprise entre 10 et 30 secondes,
- une étape de formation du revêtement métallique au cours de laquelle ladite surface est polarisée pendant une durée suffisante pour former ledit revêtement,
- une étape dite de « sortie à chaud », au cours de laquelle ladite surface est séparée du bain d'électrodéposition tandis qu'elle est encore sous polarisation électrique.

Typiquement, pour mettre en oeuvre de telles dispositions, l'homme du métier se réfèrera utilement à la demande internationale WO 2007/034116 [9] et notamment aux exemples.

Lors de l'étape (b) du procédé selon l'invention et notamment lors de l'étape de formation du revêtement telle que précédemment définie, la surface à revêtir i.e. la surface du substrat en oxyde métallique conducteur de l'électricité modifiée est polarisée en mode galvanostatique ou potentiostatique, le mode galvanostatique ou potentiostatique pouvant éventuellement être pulsé. A titre d'exemple particulier, un courant compris entre 0,1 et 50 A/dm² et, en particulier, entre 1 et 5 A/dm² est appliqué au niveau de la surface du substrat en oxyde métallique conducteur de l'électricité modifiée et ce, pendant une durée comprise entre 15 min et 2 h et notamment entre 30 min et 90 min et, en particulier, de l'ordre d'1 h (i.e. 1 h ± 15 min).

Après l'étape (b), le procédé selon la présente invention peut éventuellement comprendre une étape de recuit. Avantageusement, cette étape permet de modifier la cristallinité du dépôt de cuivre métallique de sorte à diminuer sa résistivité et, si nécessaire, d'améliorer la conformité du dépôt de cuivre métallique. Typiquement, cette étape de recuit est réalisée à une température comprise entre 30°C et 80°C, notamment entre 40°C et 60°C et, en particulier de l'ordre de 50°C (i.e. 50°C ± 5°C) et ce, pendant une durée comprise entre 10 min et 1 h et notamment entre 20 min et 45 min et, en particulier, de l'ordre de 30 min (i.e. 30 min ± 5 min).

Dans un mode de réalisation particulier du procédé de métallisation selon la présente invention, le film de cuivre métallique est formé sur la surface du substrat en oxyde métallique conducteur de l'électricité selon un motif prédéterminé. Par « motif prédéterminé », on entend, dans le cadre de la présente invention, le dépôt du film de cuivre métallique sur un (ou plusieurs) site(s) prédéfini(s) à la surface du substrat en oxyde métallique conducteur de l'électricité. En d'autres termes, seuls certains sites de la surface en oxyde métallique conducteur de l'électricité sont revêtus par un film de cuivre métallique et ce, selon un motif prédéterminé.

Dans ce mode de réalisation, le procédé selon la présente invention comprend, préalablement à l'étape (a) telle que précédemment définie, une première étape qui permet de délimiter, à la surface du substrat en oxyde métallique conducteur de l'électricité, un (ou plusieurs) site(s) qui sera/seront ultérieurement modifié(s) selon ladite étape (a) puis revêtu(s) par le film de cuivre métallique selon l'étape (b) telle que précédemment définie.

Cette étape de délimitation du procédé met en oeuvre successivement une résine photosensible et une photolithographie. Plus particulièrement, elle comprend les étapes consistant à déposer sur la surface du substrat en oxyde métallique conducteur de l'électricité une couche de résine photosensible puis à éliminer, par photolithographie, la couche de résine en des sites donnés créant ainsi ledit motif.

Ce mode de réalisation comprend, une fois l'étape (b) et éventuellement l'étape de recuit telles que précédemment définies réalisées, une étape consistant à éliminer la résine photosensible subsistante moyennant quoi le substrat en oxyde métallique conducteur de l'électricité ne présente plus de résine à sa surface.

Typiquement la résine photosensible est déposée sous forme d'une couche mince présentant une épaisseur sensiblement uniforme, comprise entre 10 nm et 100 µm et ce, par immersion (« dip coating »), par vaporisation (« spray coating») ou par centrifugation (« spin coating »).

La résine photosensible mise en oeuvre dans le cadre de la présente invention peut être une résine dite « positive », c'est-à-dire une résine dont les zones insolées sont éliminées par le développeur chimique ou une résine dite « négative » c'est-à-dire une résine dont les zones non insolées sont éliminées par le développeur chimique.

Toute résine photosensible positive ou négative connue de l'homme du métier est utilisable dans le cadre de la présente invention. A titre d'exemples non limitatifs, on peut citer la résine AZ 4562, la résine TELR-P0003PV (Tokyo OhkaKogyo Co. Ltd) en propylène glycol monométhyl éther acétate, la résine SU-8 (Shell Chemical) à base d'époxy octofonctionnelle avec un sel de triarylsulfonium comme photoiniateur ou la résine de type Novolac, à base de phénolformaldéhydique avec du diazonaphtoquinone (DNQ) comme photoinitiateur.

Suite au dépôt de la résine photosensible, cette dernière peut être chauffée à une température comprise entre 80°C et 125°C et notamment entre 90°C et 115°C pendant une durée dépendant de l'épaisseur de la couche et généralement comprise entre 1 et 30 min. Cette étape de recuit permet d'éliminer le solvant.

L'élimination par photolithographie consiste à irradier la couche de résine au moyen d'un rayonnement UV à travers un masque définissant des zones insolées et des zones non insolées puis à éliminer soit les zones insolées, soit les zones non insolées. Tout masque habituellement utilisé en photolithographie est utilisable dans le cadre de la présente invention. A titre d'exemples non limitatifs, un tel masque peut être réalisé en quartz et/ou en chrome.

Typiquement, l'irradiation (ou l'insolation) UV est comprise entre 100 et 1500 mJ.cm² et notamment entre 200 à 1000 mJ.cm². L'irradiation UV peut être effectuée pendant une durée comprise entre 1 sec et 2 min et notamment entre 5 sec et 1 min. Le cas échéant, une étape de recuit de la résine peut être nécessaire pour compléter la photopolymérisation induite par l'irradiation UV. Cette étape de recuit est effectuée, avantageusement, entre 80°C et 110°C et notamment entre 90°C et 95°C pendant 15 à 30 min.

Les zones insolées i.e. photopolymérisées pour les résines négatives ou les zones non insolées pour les résines positives deviennent insensibles à une grande majorité de solvants. Par contre, les zones insolées pour les résines positives ou les zones non insolées pour les résines négatives peuvent ultérieurement être dissoutes par un solvant, laissant apparaître la surface du substrat au niveau des sites tels que précédemment définis. L'homme du métier connaît, en fonction de la résine photosensible utilisée, le solvant également appelé le développeur à mettre en oeuvre pour éliminer certaines zones de la résine après son irradiation UV. A titre d'exemples non limitatifs, on peut citer, comme solvant utilisable, l'hydroxyde de tétraméthylammonium (TMA 238), la gammabutyrolactone (GBL), le propylène glycol méthyle éthyle acétate (PGMEA), le KOH ou le NaOH.

Suite à l'étape (b) ou l'éventuelle étape de recuisson du film de cuivre métallique, l'élimination de la résine photosensible restante nécessite l'utilisation d'un traitement et d'une (ou plusieurs) solution(s) ou solvant(s) apte(s) à retirer la résine et donc à mettre à nu la surface du substrat en oxyde métallique conducteur de l'électricité, sans éliminer le film de cuivre métallique déposé. L'homme du métier connaît les traitements et solutions à utiliser en fonction de la résine à éliminer. A titre d'exemples, un tel traitement peut se faire sous ultrasons et en utilisant un (ou plusieurs) bain(s) dans un solvant ou dans plusieurs solvants identiques ou différents tels que diméthylsulfoxyde, acétone, méthanol, éthanol ou isopropanol.

La présente invention concerne également la surface d'un substrat en oxyde métallique conducteur de l'électricité modifiée susceptible d'être obtenue suite au procédé de modification tel que précédemment défini. La partie expérimentale ci-après montre clairement que la surface d'un substrat en oxyde métallique conducteur de l'électricité soumise au procédé de modification selon l'invention impliquant un premier bain contenant du sulfate de cuivre et de l'ammoniac et un second bain contenant du tétraborohydrure de sodium présente des modifications physico-chimiques qui la distinguent de la surface du substrat en oxyde métallique conducteur de l'électricité non traitée.

La présente invention concerne aussi la surface d'un substrat en oxyde métallique conducteur de l'électricité revêtue par un film de cuivre métallique éventuellement selon un motif prédéterminé susceptible d'être obtenue suite au procédé de métallisation tel que précédemment défini. De par la mise en oeuvre du procédé de modification selon l'invention, la surface du substrat en oxyde métallique conducteur de l'électricité revêtue d'un film de cuivre métallique se distingue des surfaces obtenues par mise en oeuvre des procédés de l'art antérieur non seulement par l'absence d'une couche de germination ou d'une couche d'accroche mais aussi par les modifications physico-chimiques de la surface du substrat en oxyde métallique conducteur de l'électricité induites par l'étape de modification et qui seules permettent d'obtenir une adhérence jamais atteinte jusqu'à présent du film de cuivre métallique sur cette surface.

Le procédé de modification selon la présente invention est d'autant plus important qu'il permet la modification localisée du film d'oxyde métallique conducteur de l'électricité et notamment d'un film d'ITO en transformant le dépôt compact en un film constitué de nanoparticules d'oxyde métallique conducteur de l'électricité et notamment de nanoparticules d'ITO permettant ainsi l'adhérence d'un dépôt électrolytique de cuivre. Ce procédé constitue une avancée phare dans le domaine de l'industrie du photovoltaïque permettant de réduire drastiquement le coût de métallisation des cellules PV à hétérojonction et donc directement leur coût de production afin de les rendre compétitives sur le marché des cellules PV.

Mise à part l'industrie du photovoltaïque, la présente invention peut être rendue utile dans toute technologie utilisant un oxyde métallique conducteur de l'électricité tel que l'ITO comme les écrans à cristaux liquides, les écrans à plasma, les écrans tactiles ; les OLEDs ; les dépôts antistatiques ; les enrobages optiques, réflecteurs, et revêtements anti-reflets.

Ainsi, la présente invention concerne l'utilisation d'une surface d'un substrat en oxyde métallique conducteur de l'électricité tel qu'un substrat en ITO modifiée susceptible d'être obtenue suite au procédé de modification tel que précédemment défini ou d'une surface d'un substrat en oxyde métallique conducteur de l'électricité tel qu'un substrat en ITO revêtue par un film de cuivre métallique éventuellement selon un motif prédéterminé susceptible d'être obtenue suite au procédé de métallisation tel que précédemment défini dans le domaine des cellules photovoltaïques ; des écrans à cristaux liquides, des écrans à plasma, des écrans tactiles; des OLEDs ; des dépôts antistatiques ainsi que des enrobages optiques, réflecteurs, et revêtements anti-reflets.

D'autres caractéristiques et avantages de la présente invention apparaîtront encore à l'homme du métier à la lecture des exemples ci-dessous donnés à titre illustratif et non limitatif, en référence aux figures annexées.

### BRÈVE DESCRIPTION DES DESSINS

La Figure 1 propose une schématisation des procédés de métallisation d'une surface en ITO de l'art antérieur à savoir le procédé ECD Ni-Cu (Figure 1A) et le procédé ECD Cu (Figure 1B).

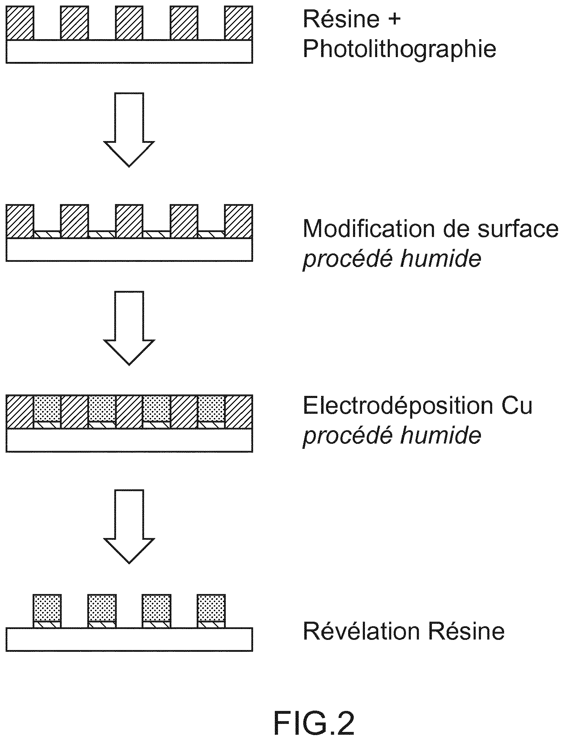

La Figure 2 est une schématisation du procédé de métallisation d'une surface en ITO selon la présente invention.
La Figure 3 présente des micrographies en microscopie électronique à balayage (MEB) d'une cellule PV à hétérojonction avec une vue de surface (Figure 3A) et une vue de profil mettant en évidence la couche d'ITO d'une épaisseur de 80 nm (Figure 3B).
La Figure 4 présente la profilométrie d'une ligne du masque photolithographié sur la cellule PV à hétérojonction avant électrodéposition (Figure 4A) et après électrodéposition (Figure 4B).
La Figure 5 présente les spectres UV d'un échantillon de cellule PV à hétérojonction non traité (ITO ref), d'un échantillon traité uniquement avec la solution ammoniacale contenant seulement du sulfate de cuivre (ITO-CuSO₄/NH₄OH), d'un échantillon de cellule traité uniquement avec la solution de NaBH₄ (ITO-NaBH₄) et d'un échantillon traité conformément au procédé selon l'invention (ITO-CuSO₄/NH₄OH-NaBH₄).
La Figure 6 présente les mesures OCP (pour « Open Circuit Potential ») sur Si des échantillons ITO seul (ITO), ITO traité par du sulfate de cuivre seul (ITO-CuSO₄), ITO traité par de l'ammoniac seul (ITO-NH₄OH) et ITO traité par une solution contenant le sulfate de cuivre et de l'ammoniac (ITO-CuSO₄/NH₄OH).
La Figure 7 présente des micrographies MEB d'un échantillon de cellule modifié selon le procédé de l'invention, i.e. plongé dans la solution de Cu(II) ammoniacal puis dans la solution de NaBH₄, avec la surface d'une ligne après traitement (Figure 7A), la mise en évidence de la structuration de surface (Figure 7B) et le profil de la couche d'ITO ainsi modifiée (Figure 7C).
La Figure 8 présente des micrographies MEB d'un échantillon de cellule modifié selon le procédé de l'invention, i.e. plongé dans la solution de Cu(II) ammoniacal puis dans la solution de NaBH₄, avec des vues en surface à différents grossissements (Figure 8A et 8B) ainsi que le spectre en analyse dispersive en énergie (EDX) associé à la micrographie MEB de la Figure 8B (Figure 8C).
La Figure 9 présente une analyse par diffractométrie de rayons X (DRX) d'un dépôt d'ITO sur Si ayant subi le traitement de modification de surface selon l'invention.
La Figure 10 présente la profilométrie d'une ligne cuivre sur cellule PV à hétérojonction formée par électrodéposition suite à la mise en oeuvre du procédé selon l'invention.
La Figure 11 présente la caractérisation par microscopie MEB d'un électrodépôt de cuivre sur ITO sans modification de la surface d'ITO (Figure 11A) et d'un électrodépôt de cuivre sur ITO suite à la modification de la surface d'ITO conformément au procédé de l'invention (Figure 11B).
La Figure 12 présente les analyses MEB (Figure 12A) et EDX (Figure 12B) de l'interface entre une ligne de cuivre formée par le procédé de métallisation selon l'invention et le film d'ITO en surface de la cellule PV à hétérojonction.

### EXPOSÉ DÉTAILLÉ DE MODES DE RÉALISATION PARTICULIERS

### I. Métallisation de la surface d'ITO selon le procédé de l'invention.

### I.1.Etape de photolithographie.

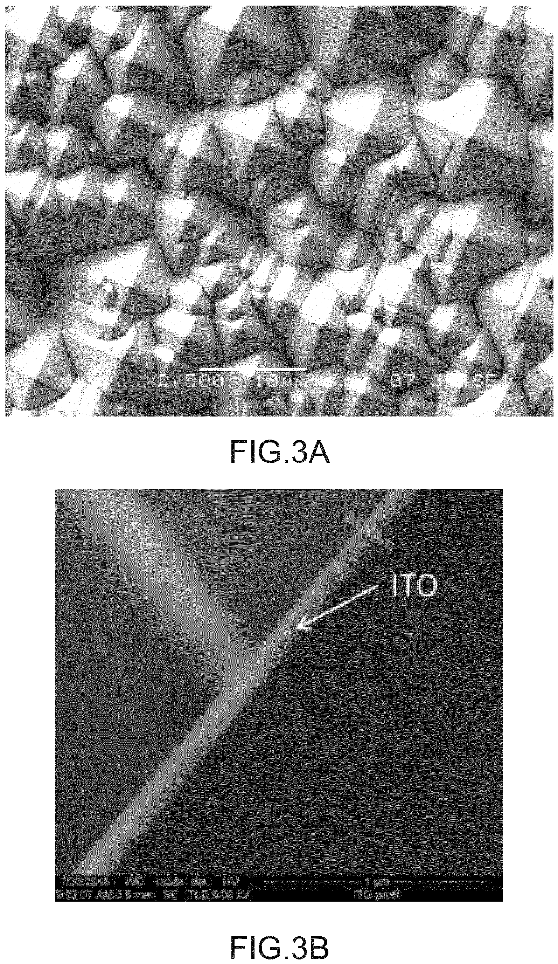

La cellule PV à hétérojonction mise en oeuvre possède en surface une structure pyramidale (Figure 3A) issue de la gravure chimique du silicium cristallin. En surface, la couche de 80 nm d'ITO est observée par MEB et illustrée à la Figure 3B.

La cellulePV à hétérojonction a tout d'abord été protégée en face arrière à l'aide d'une résine photosensible (résine positive AZ 4562). Un masque issu de la même résine photosensible a également été appliqué en face avant par photolithographie.

### I.2. Etape de modification de la surface d'ITO.

La cellule PV à hétérojonction préalablement photolithographiée est plongée dans un bain Pegactiv A2 (Pegastech), à température ambiante, pendant 15 minutes. Ce bain commercial est une solution de cuivre alcalin contenant principalement de l'ammoniac (<10%), du sulfate de cuivre (<10%) et du sulfate de nickel (<2.5%). Ce bain a ensuite été remplacé par d'autres solutions ammoniacales contenant seulement du sulfate de cuivre. Les concentrations en ammoniac utilisées varient de 1,5 mol/L à 5 mol/L et celles en CuSO₄.5H₂O varient de 0,06 à 0,2 mol/L. Toutes les solutions utilisées ont permis la modification de l'ITO avec la même efficacité et sont stables dans le temps.

Une fois le 1^{er} bain effectué, la cellule PV à hétérojonction est rincée à l'eau désionisée.

La cellule PV à hétérojonction est ensuite plongée dans une solution aqueuse contenant 0,08 M de tétraborohydrure de sodium (NaBH₄, Sigma Aldrich ≥96%), à 40°C, pendant 5 minutes. La surface de la cellule passe rapidement du bleu d'origine à un gris clair.

Une fois le 2^{nd} bain effectué, la cellule PV à hétérojonction est également rincée à l'eau désionisée.

### I.3.Etape d'électrodéposition du cuivre.

Une fois le procédé de modification de l'ITO effectué, la cellule est ensuite immergée dans le bain d'électrodéposition du cuivre.

Afin d'appliquer le courant nécessaire à la réduction d'ions Cu²⁺ en particules de cuivre métallique en surface de l'ITO, la cellule est connectée grâce à deux reprises de contact situées au bord de celle-ci.

Le courant appliqué est caractéristique du bain utilisé et est de 2,5 A/dm² pour une vitesse de croissance du film donnée à 0,5 µm/min. L'anode utilisée est une grille en titane platiné. Le bain d'électrodéposition est constitué de 75 g/L de sulfate de cuivre pentahydraté (CuSO₄.5H₂O, Sigma Aldrich), de 180 g/L d'acide sulfurique (H₂SO₄, Sigma Aldrich), de 70 ppm d'acide chlorhydrique (HCl, Sigma Aldrich) et de 2,5 ml/L d'un agent brillanteur organique (Copper Gleam PC Additive, Pegastech).

La cellule est alors métallisée par électrodépôt de cuivre à 2,5 A/dm² pendant 1 heure. Elle est ensuite retirée du bain et rincée à l'eau désionisée. Un recuit de 30 minutes à 50°C est finalement appliqué.

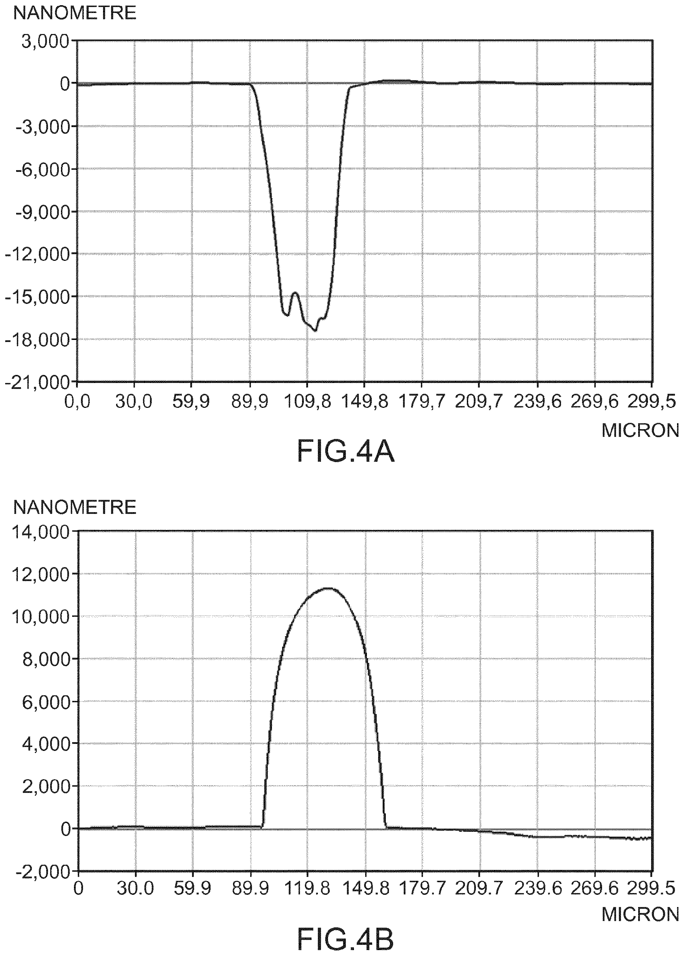

L'épaisseur du film de cuivre produit est contrôlée par profilométrie. Les lignes mesurent environ 15 µm de profondeur avant métallisation (Figure 4A) alors que, après métallisation, le masque photolithographié est entièrement rempli de cuivre métallique dense (Figure 4B).

### I.4. Etape de révélation de la résine.

La dernière étape est la révélation du masque de photolithographie. La cellule est plongée successivement et pendant quelques minutes dans deux bains de diméthylsulfoxyde (Sigma Aldrich), puis dans un bain d'éthanol (Sigma Aldrich) et enfin dans un bain d'isopropanol (Sigma Aldrich). La cellule est finalement séchée sous un léger courant d'azote, puis dans un four à 50°C pendant 10 minutes.

### II.Caractérisation des surfaces obtenues.

### II.1. Caractérisation de la surface d'ITO obtenue suite à l'étape 1.2.

Une fois la cellule PV à hétérojonction plongée successivement dans les deux bains (étape I.2 telle que précédemment définie), sa surface passe rapidement du bleu d'origine à un gris clair.

A titre de comparaison, sont utilisés un échantillon de cellule non traité (ITO ref), un échantillon de cellule traité uniquement avec la solution ammoniacale contenant seulement du sulfate de cuivre (ITO-CuSO₄/NH₄OH) et un échantillon de cellule traité uniquement avec la solution de NaBH₄ (ITO-NaBH₄). Ce dernier échantillon a été utilisé notamment dans le but de savoir si le 2^{nd} bain endommageait les propriétés optiques et électriques de l'ITO.

Des mesures de résistance par carré à l'aide d'un banc de mesure 4 pointes ont été effectuées sur les échantillons et les valeurs sont réunies dans le Tableau 1. Seul l'échantillon ayant subi les deux étapes du procédé de modification selon l'invention (ITO-CuSO_{4/}NH₄OH-NaBH₄) montre une résistance 4 fois plus élevée (328,4 Ω/□) par rapport aux autres échantillons (79-80 Ω/□). Les propriétés électriques de l'ITO ne sont donc pas modifiées par le seul bain de NaBH₄ mais par l'association des deux bains successifs.

**Tableau 1 : Mesures de résistance par carré des échantillons.**

| Echantillons | P(Ω/□) |
|---|---|
| ITO ref | 79,38 |
| ITO-CuSO₄/NH₄OH | 79,88 |
| ITO-NaBH₄ | 79,95 |
| ITO-CuSO₄/NH₄OH-NaBH₄ | 328,4 |

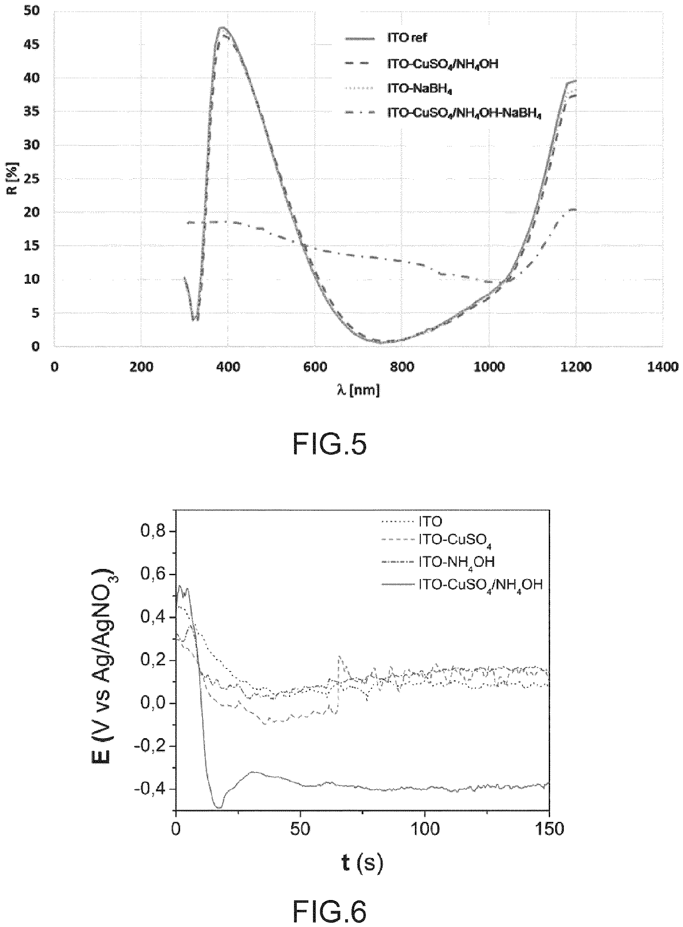

La solution de NaBH₄ ne modifie pas non plus les propriétés optiques de l'ITO. Le spectre UV-visible reste inchangé pour ITO-CuSO₄/NH₄OH et ITO-NaBH₄ (Figure 5). Seule l'association des deux étapes du procédé de modification selon l'invention modifie l'absorbance de l'ITO dans le domaine du visible.

La modification de surface produite sur l'ITO est donc rendue possible exclusivement grâce aux deux bains successifs : la solution CuSO₄-NH₄OH (cuivre ammoniacal) et la solution contenant NaBH₄.

Afin de montrer l'influence du sulfate de cuivre indépendamment de l'ammoniac, des échantillons de silicium monocristallin non texturés et recouverts d'un dépôt d'ITO de 100 nm d'épaisseur ont été plongés dans une solution aqueuse contenant le sulfate de cuivre et/ou contenant l'ammoniac.

Ces échantillons désignés ITO (référence), ITO-CuSO₄ (sulfate de cuivre seul), ITO-NH₄OH (ammoniac seul) et ITO-CuSO₄/NH₄OH (solution contenant le sulfate de cuivre et l'ammoniac) ont fait l'objet d'une analyse électrochimique par OCP (pour « Open Circuit Potential »). La tension de circuit ouvert (sans application de courant), a été mesurée directement dans la solution contenant NaBH₄ à 40°C.

Les mesures de tension en circuit ouvert présentées à la Figure 6 révèlent un potentiel identique pour ITO, ITO-CuSO₄ et ITO-NH₄OH d'environ E=0,1V et une différence de potentiel d'environ ΔE=0,5 V entre ITO et ITO-CuSO₄/NH₄OH. Cette différence de potentiel montre qu'en présence de NaBH₄, une réaction de surface se produit seulement en présence à la fois de CuSO₄ et NH₄OH.

Cette réaction de modification de surface de l'ITO fait donc intervenir des complexes cuivre-ammoniac [Cu(NH₃)₄]²⁺. A ce jour, le fonctionnement de cette étape reste inconnu.

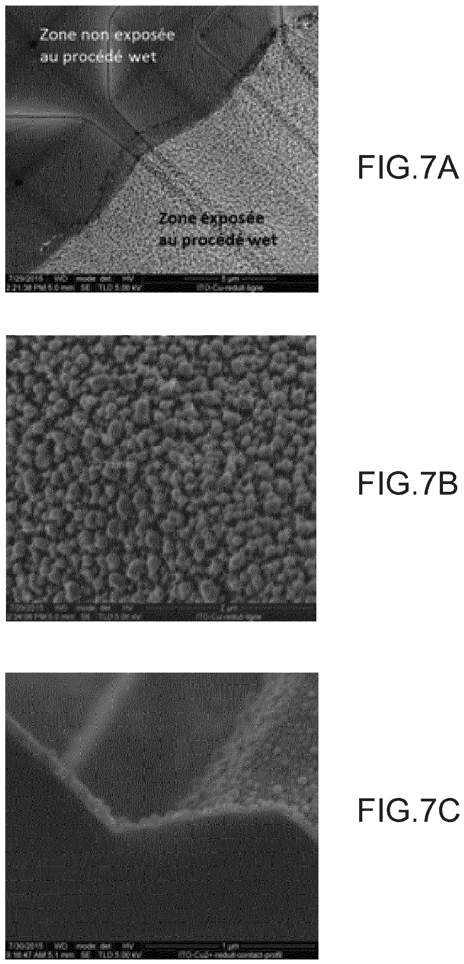

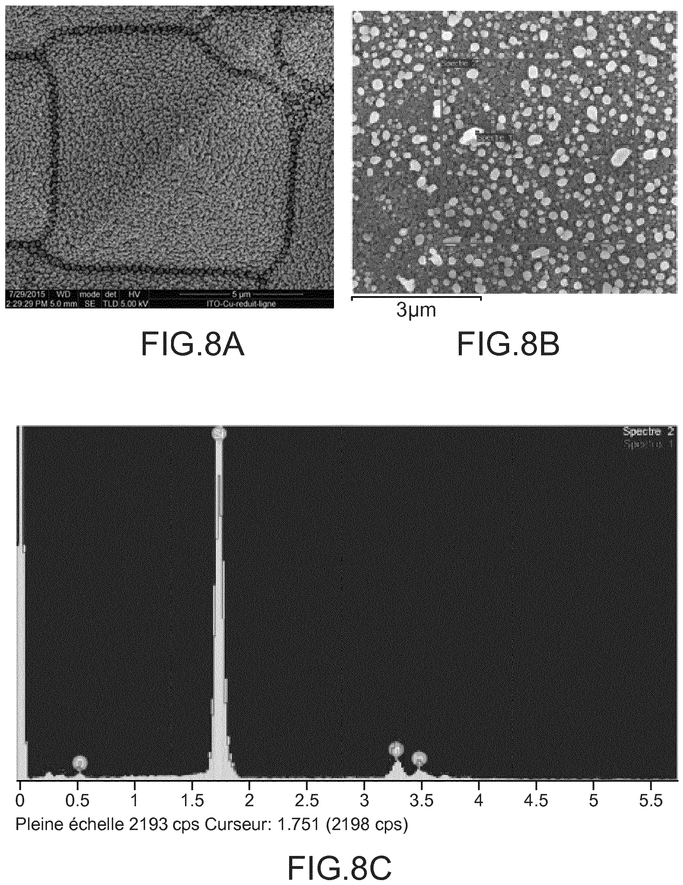

La surface d'ITO qui a subit les deux étapes du procédé de modification selon l'invention est donc la seule à présenter des différences au niveau électrique et optique. La Figure 7A montre une ligne ouverte du masque de photolithographie après traitement, une frontière nette est observée entre la zone protégée par la résine lors du traitement et la zone ayant réagi aux deux bains successifs. Le zoom effectué sur cette zone (Figure 7B, Figure 8A et Figure 8B) montre une couche uniforme constituée de grains de 80 nm à 200 nm de diamètre. La micrographie MEB de profil, présentée à la Figure 7C, montre une couche d'ITO granuleuse comparée au dépôt d'ITO initial.

L'analyse EDX présentée à la Figure 8C montre que la couche structurée est constituée exclusivement d'ITO. Aucun pic énergétique associé au cuivre n'a été observé. Le procédé selon l'invention a donc modifié les propriétés physico-chimiques du film d'ITO.

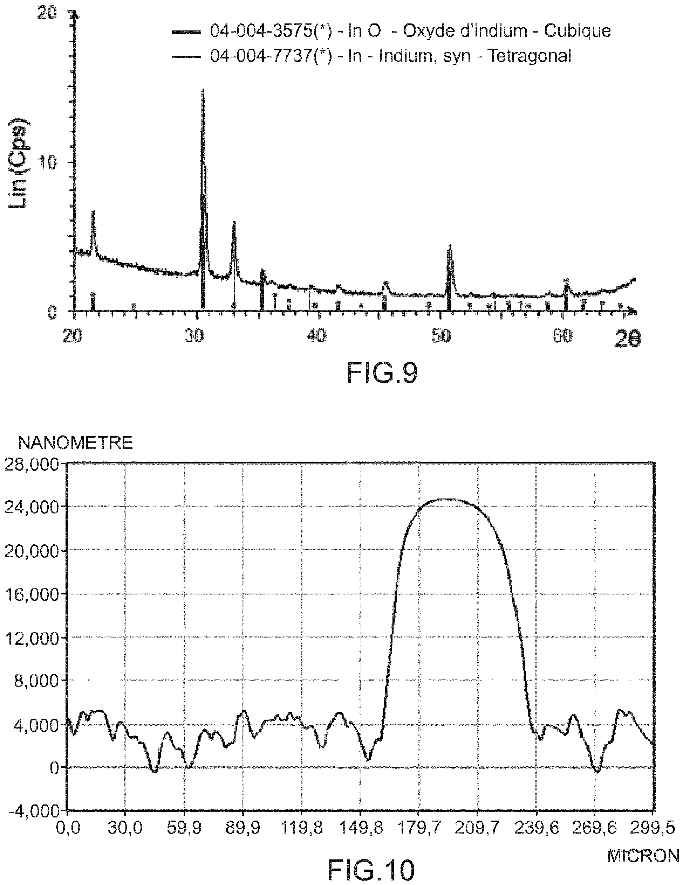

La modification morphologique du dépôt d'ITO a été mise en évidence par MEB et EDX. Pour étudier le changement de structure de l'ITO, des analyses par diffraction RX ont été effectuées à angle rasant sur un échantillon de silicium non texturé, recouvert d'ITO et ayant été plongé successivement dans les deux bains. La Figure 9 représente le diagramme DRX de l'échantillon ITO modifié.

L'analyse par diffraction aux rayons X montre que la structure cristallographique du dépôt d'ITO est modifiée. En plus de l'ITO, de l'indium métallique quadratique centré (référence ICDD 04-004-7737) est mis en évidence. En prenant en compte l'intensité des raies principales de chacun des deux composés (raie (222) pour l'ITO et raie (101) pour l'indium), la composition massique de chacune des deux phases dans le dépôt a été estimée à 16% pour l'indium métallique et 84% pour l'ITO. Il peut ainsi être affirmé que l'action seule de chacun des deux bains ne modifie pas la structure du dépôt d'ITO, mais que leur action successive permet de réduire environ 16% de l'indium sous sa forme métallique.

La combinaison des différentes analyses effectuées a permis de constater une réelle modification du dépôt d'ITO. L'échantillon d'ITO modifié montre des changements non seulement de ses propriétés optiques et électriques, mais également de ses propriétés morphologiques : la surface devient granuleuse, ce qui augmente la surface spécifique ; et de ces propriétés chimiques : présence d'indium métallique au sein du dépôt d'ITO.

Les inventeurs ont également pu montrer que le sulfate de cuivre et l'ammoniac, utilisés indépendamment, n'avaient aucun effet sur la transformation de l'ITO. Seule l'action de complexes cuivre-ammoniac tels que [Cu(NH₃)₄]²⁺ est efficace. L'hypothèse la plus probable serait que ces complexes, sous l'action de NaBH₄, jouent un rôle de catalyseur, permettant ainsi un transfert d'énergie capable de modifier le dépôt d'ITO.

### II.2. Caractérisation de l'électrodépôt de cuivre sur une surface d'ITO obtenu suite à l'étape 1.4.

Les épaisseurs de ligne de cuivre métallique obtenues suite à la mise en oeuvre du procédé défini aux paragraphes I.1 à I.4 ci-dessus, contrôlées par profilométrie sont comprises entre 18 et 24 µm (Figure 10).

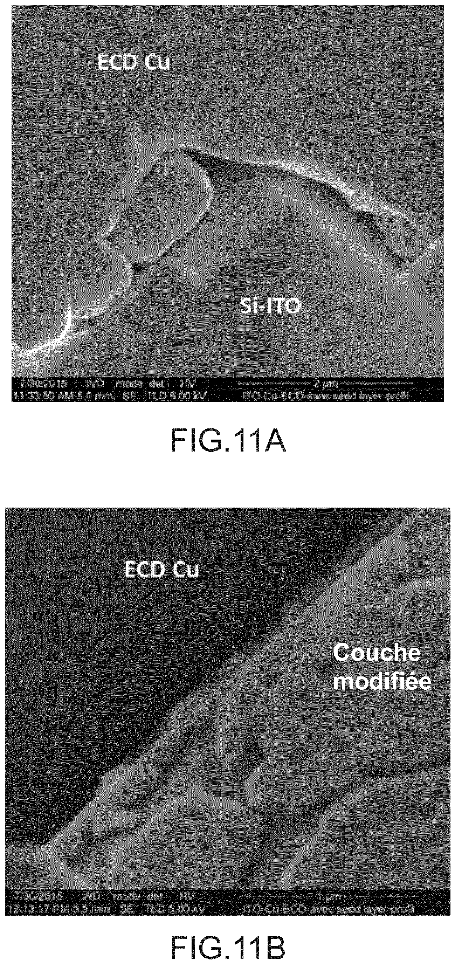

A titre de comparaison, la Figure 11A montre une micrographie de profil d'un électrodépôt de cuivre effectué sur cellule PV à hétérojonction sans modification de cette dernière, les zones de vide présentes à l'interface montrent parfaitement l'absence d'un véritable contact entre le cuivre et l'ITO induisant une perte de l'adhérence et un mauvais contact électrique.

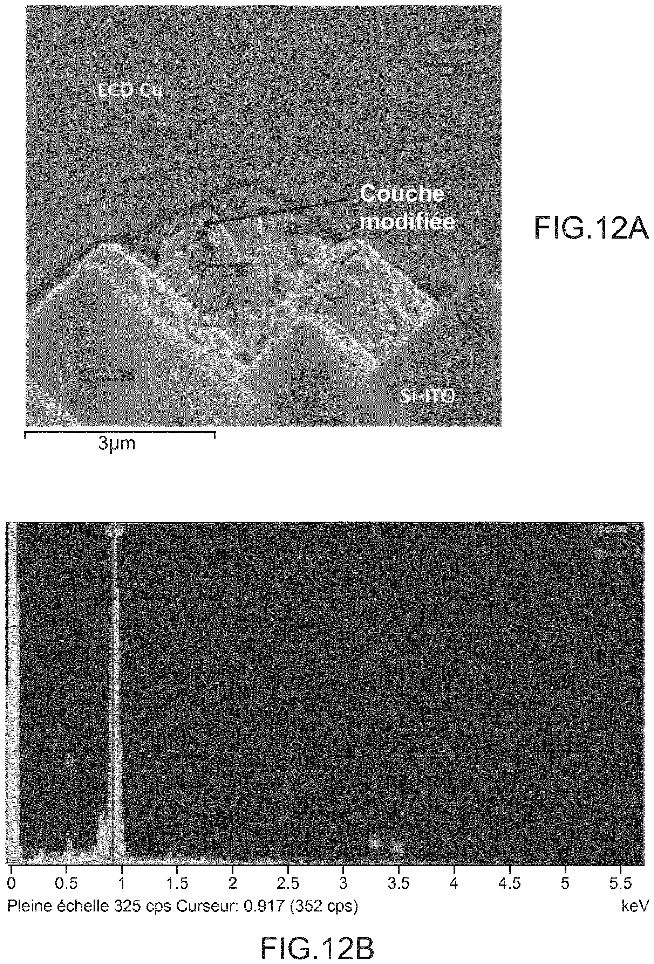

Au contraire, la Figure 11B montre une micrographie de profil de l'électrodépôt de cuivre sur cellule PV à hétérojonction utilisant le procédé de l'invention i.e. avec modification de la surface d'ITO. Une couche correspondant à la modification de la surface d'ITO et servant de couche d'accroche est présente. Elle permet ainsi une bonne adhérence du métal sur l'ITO, ce qui génère un contact électrique de très bonne qualité. La présence de cette couche d'accroche est révélée par MEB (Figure 12A) et par analyses EDX, (Figure 12B).

Une fois le procédé de métallisation de la cellule terminé, des mesures de résistance de contact ont été effectuées. Les mesures présentées dans le Tableau 2 ci-après montrent que même si les résistances de contact Cu-ITO des cellules métalllisées conformément au procédé selon l'invention sont de l'ordre de 10 fois supérieures aux valeurs de référence obtenues pour des cellules métallisées selon le procédé ECD Cu (procédé de référence), elles restent tout de même faibles et attestent d'un bon contact électrique à l'interface Cu-ITO.

**Tableau 2 : Mesures TLM déterminant la résistance de contact Cu-ITO**

| | **R carré** | **R contact** | **R spécifique de contact** | **Largeur d'un plot** |
|---|---|---|---|---|
| | **Rsheet (Ohm)** | **Rc (Ohm)** | **Rhoc (Ohm.cm²)** | **Lt (µm)** |
| **Procédé Invention Cellule 1** | 76 | 1,26 | 8,43E-03 | 99 |
| **Procédé Invention Cellule 2** | 78 | 2,02 | 1,38E-03 | 99 |
| **Procédé ECD Cu** | 57 | 0,0989 | 1,71E-04 | 17 |

Des tests de performances électriques des cellules ont finalement été effectués après découpe laser des cellules. La découpe laser définit autour de la grille une surface active de 107 cm², afin d'isoler la partie active ou la grille métallique du contact avant. Les rendements électriques sont très satisfaisants (supérieures à 20%), et comparables à ceux obtenus par le procédé ECD Cu. Les caractéristiques électriques des cellules testées sont réunies dans le Tableau 3 ci-dessous.

**Tableau 3 : Mesures électriques I(V) sur cellules PV à hétérojonction avec contact avant en cuivre par le procédé selon l'invention et le procédé ECD Cu (protocole de référence).**

| | | **1 sun IV curve** | | | |
|---|---|---|---|---|---|
| | **Plaque** | **Voc [mV]** | **Jsc [mA.cm⁻²]** | **FF [%]** | **η [%]** |
| **Procédé Invention** | **Cellule 1** | 723,9 | 37,4 | 77,9 | 21,1 |
| **Procédé Invention** | **Cellule 2** | 714,1 | 37,4 | 77,0 | 20,6 |
| **Procédé Invention** | **Moyenne** | 719,0 | 37,4 | 77,5 | **20,9** |
| **Procédé ECD Cu** | **Moyenne** | 714,1 | 37,4 | 78,1 | 20,8 |

### RÉFÉRENCES BIBLIOGRAPHIQUES

**[1]** Bartsch et al, 2014, "21.8% Efficient n-type Solar Cells with Industrially Feasible Plated Metallization", Energ. Proc., vol. 55, pages 400-409.
**[2]** Geisler et al, 2014, "Continuous wave laser processing for electrical and mechanicalstable solar cells with Ni-Cu metallization", 4th International Conférence on Silicon Photovoltaics, SiliconPV, Energ. Proc., vol. 55, pages 665 - 669.
**[3]** Hernández et al, 2013, "High efficiency copper electroplated heterojunction solar cells and modules - the path towards 25% cell efficiency", 28th European Photovoltaic Solar Energy Conférence and Exhibition.
**[4]** Tous et al, 2014, "Large-area hybrid silicon heterojunction solar cells with Ni/Cu plated front contacts", 4th International Conférence on Silicon Photovoltaics, SiliconPV, Energ. Proc., vol. 55, pages 715-723.
**[5]** Geissbuhler et al, 2014, "Silicon Heterojunction Solar Cells With Copper-Plated Grid Electrodes: Status and Comparison With Silver Thick-Film Techniques", IEEE J. of Photovolt.,vol. 4, pages 1055-1062.
**[6]** Papet et al, 2013, "Heterojunction solar cells with electroplated Ni/Cu front electrode", 28th European Photovoltaic Solar Energy Conférence and Exhibition.
**[7]** Masuko et al, 2014, "Achievement of more than 25% conversion efficiency with crystalline silicon heterojunction solar cell", IEEE J. Photovolt., vol. 4, pages 1433-1435.
**[8]** Khanna et al, 2015, "Screen-printed masking of transparent conductive oxide layers for copper plating of silicon heterojunction cells", Appl. Surf. Sci., vol. 349, pages 880-886.
**[9]** Demande internationale WO 2007/034116 au nom d'Alchimer, publiée le 29 mars 2007.

## Revendications

1. Procédé pour modifier la surface d'un substrat en oxyde métallique conducteur de l'électricité, ledit procédé comprenant les étapes suivantes consistant à :
i) mettre en contact la surface dudit substrat en oxyde métallique conducteur de l'électricité avec une solution contenant au moins un ion cuivrique (Cu²⁺) et au moins de l'ammoniac puis laver et éventuellement sécher la surface dudit substrat en oxyde métallique conducteur de l'électricité ainsi obtenue ;
ii) mettre en contact la surface dudit substrat en oxyde métallique conducteur de l'électricité obtenue suite à l'étape (i) avec une solution contenant du tétraborohydrure de sodium puis laver et éventuellement sécher la surface dudit substrat en oxyde métallique conducteur de l'électricité.

2. Procédé selon la revendication 1, **caractérisé en ce que**, lors de ladite étape (i), l'ion Cu²⁺ se trouve, dans ladite solution, sous forme d'un sel de cuivre, avantageusement choisi dans le groupe constitué par un nitrate, un sulfate, un acétate, un halogénure, un tétrafluoroborate et l'une quelconque de leurs formes hydratées.

3. Procédé selon la revendication 2, **caractérisé en ce que** ledit sel de cuivre est présent, dans ladite solution, en une quantité comprise entre 0,05 et 0,25 mol/L et avantageusement entre 0,06 et 0,2 mol/L.

4. Procédé selon l'une quelconque des revendications 1 à 3, **caractérisé en ce que**, lors de ladite étape (i), l'ammoniac est présent, dans ladite solution, en une quantité comprise entre 1 et 6 mol/L et avantageusement entre 1,5 et 5 mol/L.

5. Procédé selon l'une quelconque des revendications 1 à 4, **caractérisé en ce que** ladite étape (i) est effectuée à une température comprise entre 10°C et 30°C, avantageusement entre 15°C et 25°C et, plus particulièrement, à température ambiante et ce, généralement durant de 1 min à 1 h, notamment durant de 5 min à 30 min et, en particulier, durant 15 min.

6. Procédé selon l'une quelconque des revendications 1 à 5, **caractérisé en ce que**, lors de ladite étape (ii), le tétraborohydrure de sodium est présent en une quantité comprise entre 0,03 et 0,15 mol/L, avantageusement entre 0,06 et 0,1 mol/L et, en particulier, de 0,08 mol/L.

7. Procédé selon l'une quelconque des revendications 1 à 6, **caractérisé en ce que** ladite étape (ii) est effectuée à une température comprise entre 30°C et 60°C, avantageusement entre 35°C et 50°C et, plus particulièrement, à une température de 40°C et ce, généralement durant de 1 à 15 min, notamment durant de 2 à 10 min et, en particulier, durant 5 min.

8. Procédé pour former un film de cuivre métallique sur la surface d'un substrat en oxyde métallique conducteur de l'électricité, ledit procédé comprenant les étapes suivantes consistant à :
a) préparer une surface d'un substrat en oxyde métallique conducteur de l'électricité modifiée conformément au procédé de modification tel que défini à l'une quelconque des revendications 1 à 7 ;
b) électrodéposer du cuivre métallique sur la surface du substrat modifiée préparée lors de ladite étape (a).

9. Procédé selon la revendication 8, **caractérisé en ce que** ladite étape (b) met en oeuvre un bain d'électrodéposition comprenant des ions Cu²⁺ se trouvant sous forme d'un sel de cuivre.

10. Procédé selon la revendication 9, **caractérisé en ce que** ledit bain d'électrodéposition est une solution aqueuse acide contenant des ions Cu²⁺.

11. Procédé selon l'une quelconque des revendications 8 à 10, **caractérisé en ce que** le film de cuivre métallique est formé sur la surface du substrat en oxyde métallique conducteur de l'électricité selon un motif prédéterminé et **en ce que** ledit procédé comprend :
- préalablement à ladite étape (a), des étapes consistant à déposer sur la surface du substrat en oxyde métallique conducteur de l'électricité une couche de résine photosensible puis à éliminer, par photolithographie, la couche de résine en des sites donnés créant ainsi ledit motif et
- une fois ladite étape (b) réalisée, une étape consistant à éliminer la résine photosensible subsistante moyennant quoi le substrat en oxyde métallique conducteur de l'électricité ne présente plus de résine à sa surface.

12. Surface d'un substrat en oxyde métallique conducteur de l'électricité modifiée susceptible d'être obtenue suite au procédé de modification tel que défini à l'une quelconque des revendications 1 à 7.

13. Surface d'un substrat en oxyde métallique conducteur de l'électricité revêtue par un film de cuivre métallique éventuellement selon un motif prédéterminé susceptible d'être obtenue suite au procédé de métallisation tel que défini à l'une quelconque des revendications 8 à 11.

14. Utilisation d'une surface d'un substrat en oxyde métallique conducteur de l'électricité modifiée selon la revendication 12 ou d'une surface d'un substrat en oxyde métallique conducteur de l'électricité revêtue par un film de cuivre métallique éventuellement selon un motif prédéterminé selon la revendication 13 dans le domaine des cellules photovoltaïques ; des écrans à cristaux liquides, des écrans à plasma, des écrans tactiles ; des OLEDs ; des dépôts antistatiques ainsi que des enrobages optiques, réflecteurs, et revêtements anti-reflets.

15. Procédé selon l'une quelconque des revendications 1 à 11, surface selon la revendication 12 ou 13 ou utilisation selon la revendication 14, caractérisé(e) en ce que ledit oxyde métallique conducteur de l'électricité est de l'ITO.

## Patentansprüche

1. Verfahren zum Modifizieren der Oberfläche eines Substrats aus elektrisch leitfähigem Metalloxid, wobei das Verfahren die nachfolgenden Schritte umfasst:
i) Inkontaktbringen der Oberfläche des Substrats aus elektrisch leitfähigem Metalloxid mit einer Lösung, die zumindest ein Kupferion (Cu²⁺) und zumindest Ammoniak enthält, dann Spülen und gegebenenfalls Trocknen der so erhaltenen Oberfläche des Substrats aus elektrisch leitfähigem Metalloxid;
ii) Inkontaktbringen der aus Schritt (i) erhaltenen Oberfläche des Substrats aus elektrisch leitfähigem Metalloxid mit einer Lösung, die Natriumtetraborhydrid enthält, dann Spülen und gegebenenfalls Trocknen der Oberfläche des Substrats aus elektrisch leitfähigem Metalloxid.

2. Verfahren nach Anspruch 1, **dadurch gekennzeichnet, dass** in Schritt (i) das Cu²⁺-Ion in der Lösung in Form eines Kupfersalzes vorliegt, vorteilhaft ausgewählt aus der Gruppe bestehend aus Nitrat, Sulfat, Acetat, Halogenid, Tetrafluorborat und einer ihrer hydratisierten Formen.

3. Verfahren nach Anspruch 2, **dadurch gekennzeichnet, dass** das Kupfersalz in der Lösung in einer Menge zwischen 0,05 und 0,25 mol/L und vorteilhaft zwischen 0,06 und 0,2 mol/L vorliegt.

4. Verfahren nach einem der Ansprüche 1 bis 3, **dadurch gekennzeichnet, dass** in Schritt (i) das Ammoniak in der Lösung in einer Menge zwischen 1 und 6 mol/L und vorteilhaft zwischen 1,5 und 5 mol/L vorliegt.

5. Verfahren nach einem der Ansprüche 1 bis 4, **dadurch gekennzeichnet, dass** der Schritt (i) bei einer Temperatur zwischen 10 °C und 30 °C, vorteilhaft zwischen 15 °C und 25 °C und insbesondere bei Raumtemperatur erfolgt, und zwar im Allgemeinen 1 min bis 1 h lang, insbesondere 5 min bis 30 min lang und ganz besonders 15 min lang erfolgt.

6. Verfahren nach einem der Ansprüche 1 bis 5, **dadurch gekennzeichnet, dass** in Schritt (ii) das Natriumtetraborhydrid in einer Menge zwischen 0,03 und 0,15 mol/L, vorteilhaft zwischen 0,06 und 0,1 mol/L und insbesondere von 0,08 mol/L vorliegt.

7. Verfahren nach einem der Ansprüche 1 bis 6, **dadurch gekennzeichnet, dass** der Schritt (ii) bei einer Temperatur zwischen 30 °C und 60 °C, vorteilhaft zwischen 35 °C und 50 °C und insbesondere bei einer Temperatur von 40 °C, zwar im Allgemeinen 1 bis 15 min lang, insbesondere 2 bis 10 min lang und ganz besonders 5 min lang erfolgt.

8. Verfahren zum Bilden eines Kupfermetallfilms auf der Oberfläche eines Substrats aus elektrisch leitfähigem Metalloxid, wobei das Verfahren die nachfolgenden Schritte umfasst:
a) Bereitstellen einer Oberfläche eines Substrats aus elektrisch leitfähigem Metalloxid, die mit dem Modifizierungsverfahren nach einem der Ansprüche 1 bis 7 modifiziert wurde;
b) Elektroabscheiden von Kupfermetall auf die in Schritt (a) bereitgestellte, modifizierte Oberfläche des Substrats.

9. Verfahren nach Anspruch 8, **dadurch gekennzeichnet, dass** der Schritt (b) ein Elektroabscheidungsbad umfasst, der Cu²⁺-Ionen enthält, die in Form eines Kupfersalzes vorliegen.

10. Verfahren nach Anspruch 9, **dadurch gekennzeichnet, dass** das Elektroabscheidungsbad eine saure wässrige Lösung ist, die Cu²⁺-Ionen enthält.

11. Verfahren nach einem der Ansprüche 8 bis 10, **dadurch gekennzeichnet, dass** der Kupfermetallfilm auf der Oberfläche des Substrats aus elektrisch leitfähigem Metalloxid nach einem vorbestimmten Muster gebildet wird und dass das Verfahren umfasst:
- vor Schritt (a) Schritte zum Abscheiden einer lichtempfindlichen Harzschicht auf die Oberfläche des Substrats aus elektrisch leitfähigem Metalloxid, dann Entfernen der Harzschicht durch Photolithographie an vorgegebenen Stellen, wodurch das Muster geschaffen wird, und
- nach erfolgtem Schritt (b) einen Schritt zum Entfernen von dem verbleibenden lichtempfindlichen Harz, wodurch das Substrat aus elektrisch leitfähigem Metalloxid kein Harz mehr auf seiner Oberfläche aufweist.

12. Modifizierte Oberfläche eines Substrats aus elektrisch leitfähigem Metalloxid, die mit einem Modifizierungsverfahren nach einem der Ansprüche 1 bis 7 erhalten werden kann.

13. Oberfläche eines Substrats aus elektrisch leitfähigem Metalloxid, die mit einem Kupfermetallfilm, gegebenenfalls nach einem vorbestimmten Muster, beschichtet ist und mit dem Metallisierungsverfahren nach einem der Ansprüche 8 bis 11 erhalten werden kann.

14. Verwendung einer Oberfläche eines Substrats aus elektrisch leitfähigem Metalloxid, die nach Anspruch 12 modifiziert ist, oder einer Oberfläche eines Substrats aus elektrisch leitfähigem Metalloxid, die mit einem Kupfermetallfilm, gegebenenfalls nach einem vorbestimmten Muster, nach Anspruch 13 beschichtet ist, im Gebiet der Photovoltaikzellen; Flüssigkristallbildschirmen, Plasmabildschirmen, berührungsempfindlichen Bildschirmen, OLEDs; antistatischen Abscheidungen sowie optischen Beschichtungen, Reflektoren und Antireflexbeschichtungen.

15. Verfahren nach einem der Ansprüche 1 bis 11, Oberfläche nach Anspruch 12 oder 13 oder Verwendung nach Anspruch 14, **dadurch gekennzeichnet, dass** das elektrisch leitfähige Metalloxid ITO ist.

## Claims

1. Method for modifying the surface of an electrically conductive metal oxide substrate, said method comprising the following steps consisting in:
i) bringing into contact the surface of said electrically conductive metal oxide substrate with a solution containing at least one copper ion (Cu²⁺) and at least ammonia then washing and optionally drying the surface of said electrically conductive metal oxide substrate thus obtained;
ii) bringing into contact the surface of said electrically conductive metal oxide substrate obtained following step (i) with a solution containing sodium tetraborohydride then washing and optionally drying the surface of said electrically conductive metal oxide substrate.

2. Method according to claim 1, **characterised in that**, during said step (i), the Cu²⁺ ion is, in said solution, in the form of a copper salt, advantageously selected from the group consisting of a nitrate, a sulphate, an acetate, a halide, a tetrafluoroborate and any of the hydrated forms thereof.

3. Method according to claim 2, **characterised in that** said copper salt is present, in said solution, in a quantity comprised between 0.05 and 0.25 mol/L and advantageously between 0.06 and 0.2 mol/L.

4. Method according to any of claims 1 to 3, **characterised in that**, during said step (i), ammonia is present, in said solution, in a quantity comprised between 1 and 6 mol/L and advantageously between 1.5 and 5 mol/L.

5. Method according to any of claims 1 to 4, **characterised in that** said step (i) is carried out at a temperature comprised between 10°C and 30°C, advantageously between 15°C and 25°C and, more particularly, at room temperature and generally for 1 min to 1 h, notably for 5 min to 30 min and, in particular, for 15 min.

6. Method according to any of claims 1 to 5, **characterised in that**, during said step (ii), sodium tetraborohydride is present in a quantity comprised between 0.03 and 0.15 mol/L, advantageously between 0.06 and 0.1 mol/L and, in particular, of 0.08 mol/L.

7. Method according to any of claims 1 to 6, **characterised in that** said step (ii) is carried out at a temperature comprised between 30°C and 60°C, advantageously between 35°C and 50°C and, more particularly, at a temperature of 40°C and generally for 1 to 15 min, notably for 2 and 10 min and, in particular, for 5 min.

8. Method for forming a film of copper metal on the surface of an electrically conductive metal oxide substrate, said method comprising the following steps consisting in:
a) preparing a surface of an electrically conductive metal oxide substrate modified in accordance with the modification method such as defined in any of claims 1 to 7;
b) electrodepositing copper metal on the surface of the modified substrate prepared during said step (a).

9. Method according to claim 8, **characterised in that** said step (b) implements an electrodeposition bath comprising Cu²⁺ ions being in the form of a copper salt.

10. Method according to claim 9, **characterised in that** said electrodeposition bath is an aqueous acid solution containing Cu²⁺ ions.

11. Method according to any of claims 8 to 10, **characterised in that** the film of copper metal is formed on the surface of the electrically conductive metal oxide substrate according to a predetermined pattern and **in that** said method comprises:
- prior to said step (a), steps consisting in depositing on the surface of the electrically conductive metal oxide substrate a layer of photosensitive resin then eliminating, by photolithography, the resin layer at given sites thus creating said pattern and
- once said step (b) has been carried out, a step consisting in eliminating the remaining photosensitive resin whereby the electrically conductive metal oxide substrate no longer has resin on the surface thereof.

12. Modified surface of an electrically conductive metal oxide substrate capable of being obtained following the modification method such as defined in any of claims 1 to 7.

13. Surface of an electrically conductive metal oxide substrate coated with a film of copper metal optionally according to a predetermined pattern capable of being obtained following the metallisation method such as defined in any of claims 8 to 11.

14. Use of a modified surface of an electrically conductive metal oxide substrate according to claim 12 or a surface of an electrically conductive metal oxide substrate coated with a film of copper metal optionally according to a predetermined pattern according to claim 13 in the field of photovoltaic cells; liquid crystal screens, plasma screens, touch screens; OLEDs; antistatic deposits as well as optical coatings, reflector, and anti-reflection coatings.

15. Method according to any of claims 1 to 11, surface according to claim 12 or 13 or use according to claim 14, **characterised in that** said electrically conductive metal oxide is ITO.
